# FASCICULE DE BREVET EUROPEEN

(11) **EP 0 869 595 B1**
(45) Date de publication et mention de la délivrance du brevet: **03.07.2002**
(21) Numéro de dépôt: 98400738.5
(22) Date de dépôt: 30.03.1998
(51) Int. Cl.: H02B 1/04

(54) **Ensemble d'appareils électriques, notamment de départ-moteur**
Mehrheit von elektrischen geräten, insbesondere für motorsteuerung
Assembly of electrical apparatuses, particularly for motor starter block

(30) Priorité: 01.04.1997 FR 9704042
(43) Date de publication de la demande: 07.10.1998
(73) Titulaire: Schneider Electric Industries SA, 92500 Rueil-Malmaison (FR)
(72) Inventeur: Girard, Michel, 21910 Corcelles-Les-Citeaux (FR); Rix, Philippe, 21000 Dijon (FR)

(56) Documents cités:
- EP-A- 0 425 393
- EP-A- 0 534 538
- EP-A- 0 588 712
- DE-A- 19 515 923

## Description

La présente invention concerne un ensemble d'appareils électriques affectés à la commande de puissance de charges, notamment un ensemble de départ-moteur, comprenant pour chaque charge une paire d'appareils montés sur un socle, chaque paire d'appareils comportant un disjoncteur et un contacteur munis de bornes de puissance et de contrôle, des conducteurs de contrôle de l'ensemble d'appareils à partir d'un automate programmable ou d'un bus étant associés au socle.

Des ensembles d'appareils de ce type sont bien connus et doivent pouvoir se monter et se démonter facilement. En particulier, on assiste à une tendance croissante à connecter des appareils de départ-moteur à des bus acheminant des signaux de contrôle ; le terme "contrôle" est pris ici au sens large et désigne aussi bien la commande des appareils de l'ensemble que la signalisation d'état de ces appareils ou la commande d'autres appareils en fonction de leur état.

Le document DE-2 95 07456 décrit un dispositif de départ-moteur dans lequel un disjoncteur et des contacteurs sont disposés sur un support, tandis qu'un circuit imprimé servant à connecter à un bus les bornes de commande des contacteurs et des bornes du disjoncteur possède des borniers directement enfichables sur les bornes des contacteurs. Avec ce dispositif, il est nécessaire de câbler en contrôle le circuit imprimé au disjoncteur et en puissance le disjoncteur aux contacteurs.

Le document EP-A-0 425 393 décrit un ensemble selon le préambule de la revendication 1.

Il est souhaitable de simplifier le câblage de puissance et de contrôle d'ensembles d'appareils du type décrit.

L'invention a pour but de faciliter le montage et le démontage d'ensembles d'appareils électriques affectés à la commande de puissance de charges, notamment d'ensembles de départ-moteur, en simplifiant leur câblage de contrôle et/ou de puissance.

Selon l'invention, le socle présente des broches de puissance et de contrôle coopérant avec les bornes respectives de puissance et de contrôle des appareils, et à la paire d'appareils est associé au moins un bloc auxiliaire de connexion qui est fixé à l'un au moins des appareils de la paire, connecté à des bornes de contrôle de cet appareil et doté de conducteurs de contrôle raccordés aux broches de contrôle du socle de manière telle que la paire d'appareils soit connectée au socle avec une liaison de contrôle précâblée. Le terme "contacteur" désigne ici un contacteur simple ou inverseur aussi bien qu'un couple de contacteurs montés en inverseur.

Le câblage de contrôle est simplifié grâce au bloc auxiliaire.

Le bloc auxiliaire peut être un bloc intermédiaire amovible disposé entre le disjoncteur et le contacteur, lequel bloc intermédiaire assure l'interconnexion de puissance entre le disjoncteur et le contacteur ainsi que la connexion de contrôle du contacteur avec le socle.

Il peut aussi être un bloc terminal attenant au contacteur et assurant la connexion de contrôle du contacteur. Le bloc terminal peut comporter un relais de commande de la bobine de l'électroaimant du contacteur, un organe amovible de câblage du moteur dans lequel sont serrés les câbles reliant les bornes aval de puissance du contacteur à la charge et formant ainsi un organe mémorisant l'ordre de câblage, ainsi qu'un shunt offrant la possibilité d'une commande externe du contacteur.

La description est faite ci-après d'un mode de réalisation non limitatif de l'invention, en regard des dessins annexés.

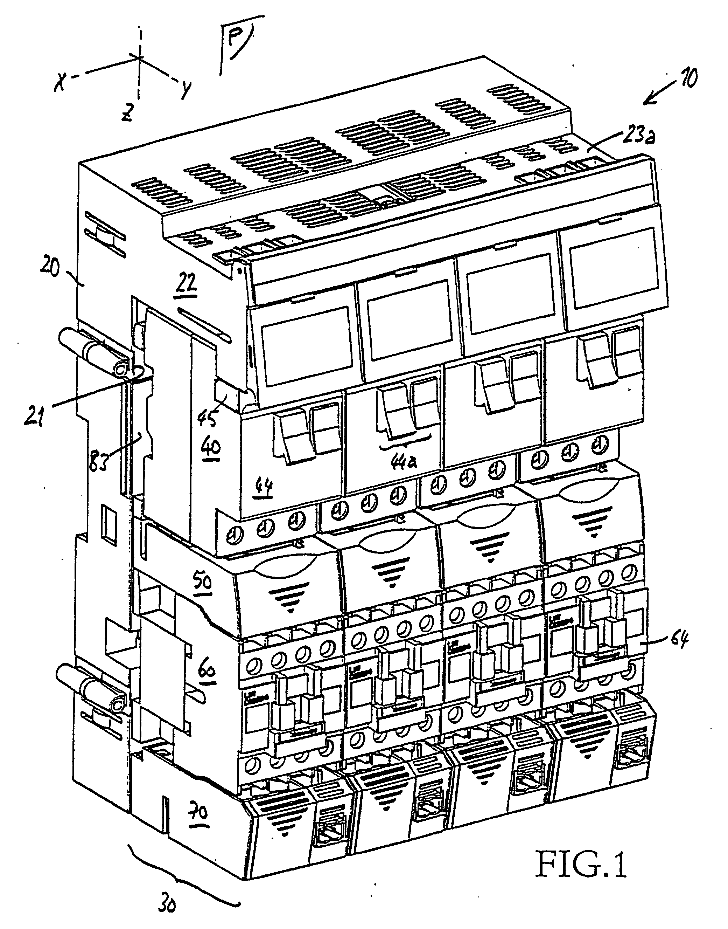

La figure 1 représente en perspective un ensemble d'appareils de départ-moteur conforme à l'invention.
La figure 2 montre en perspective de dessous le socle de l'ensemble de la figure 1.
La figure 3 est une vue de côté d'une varianre de réalisation de l'ensemble.
La figure 4 montre en perspective de dessous un bloc intermédiaire simple.
La figure 5 représente en vue éclatée le bloc de la figure 4.
La figure 6 montre en perspective éclatée un disjoncteur associé à un contacteur-inverseur au moyen d'un bloc intermédiaire double.
La figure 7 montre en perspective de dessous un bloc terminal.
La figure 8 montre le bloc terminal en vue éclatée.

Le dispositif représenté est un ensemble de départ-moteur à quatre éléments, mais il va de soi qu'il peut comprendre un nombre d'éléments de départ différent, par exemple un, deux ou huit. De même, le dispositif peut être assemblé et connecté par tous moyens usuels à un dispositif voisin.

L'ensemble de départ-moteur 10 comprend un socle 20 sur lequel sont emboîtés et connectés des sous-ensembles de départ 30. Chaque sous-ensemble comprend pour commander une charge une paire d'appareils électriques et deux blocs de connexion associés, à savoir un disjoncteur 40, un bloc intermédiaire 50, un contacteur 60 et un bloc terminal 70. Le contacteur 60 peut dans certaines applications être constitué par un inverseur ou bien par deux contacteurs montés en inverseur. Le socle 20 peut être fixé à l'arrière à un support par des moyens de fixation usuels : éléments d'encliquetage, vis, etc..

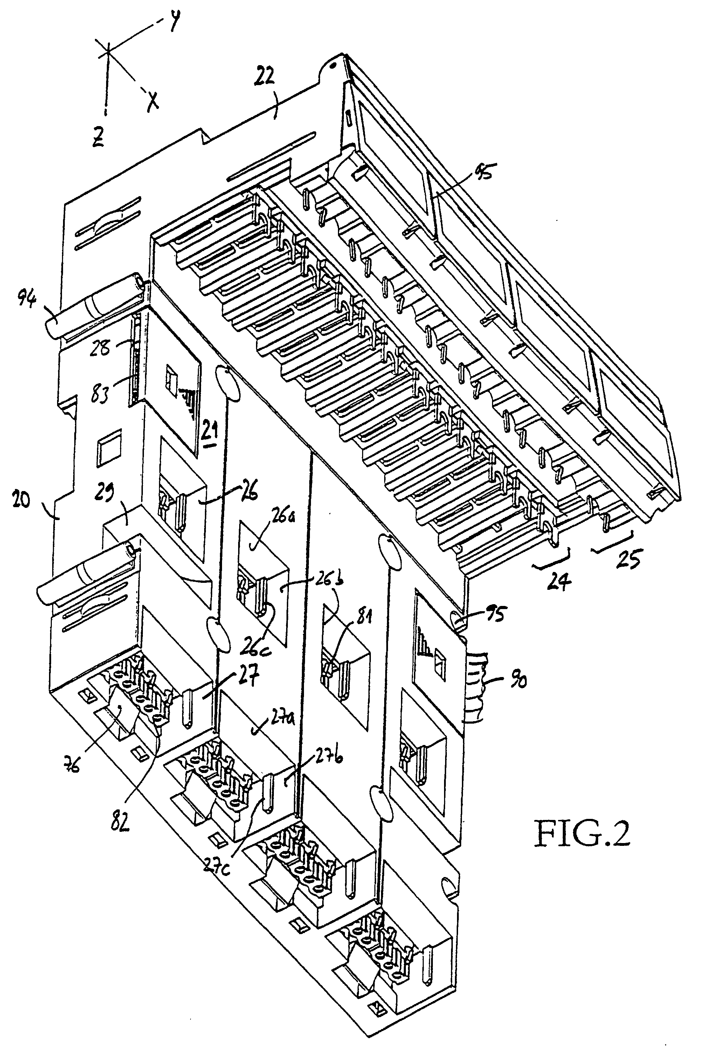

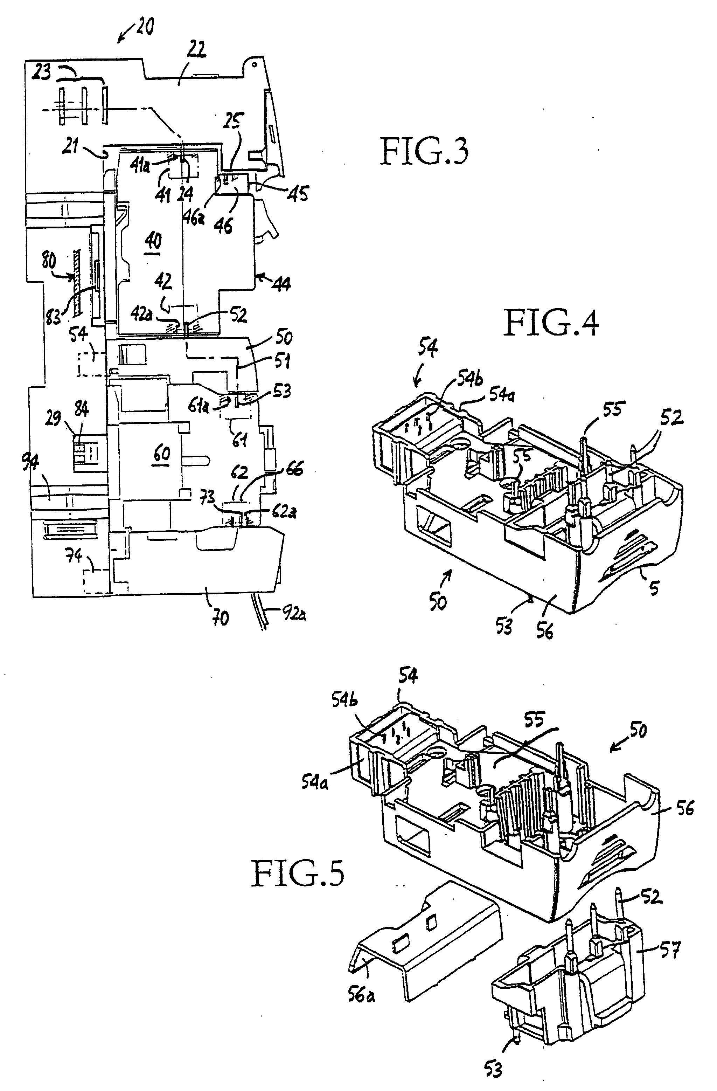

Le socle 20 comprend un corps de faible profondeur doté d'une aire frontale de support 21 (voir figure 2) généralement parallèle à un plan P pour porter les sous-ensembles 30 et assurer les interconnexions entre leurs composants et, en saillie à partir du corps selon une direction Y perpendiculaire au plan P, une avancée supérieure 22 en forme de console ; le socle loge un jeu de conducteurs d'alimentation 23, par exemple des barres (voir figure 3), qui s'étendent selon une direction générale X parallèle à P et sont reliées d'une part à un raccordement d'alimentation latéral ou frontal 23a et d'autre part à des broches de connexion de puissance 24 destinées à se connecter au disjoncteur; la console 22 présente aussi des broches de connexion de contrôle 25 destinées à se connecter à un additif lui-même rapporté au disjoncteur ; les broches 24 et 25 s'étendent selon une direction Z parallèle à P et perpendiculaire à X et Y. Le socle 20 loge un circuit imprimé 80 qui est parallèle à P et assure les interconnexions de contrôle de l'ensemble, via des connecteurs 81,82 et la connexion externe de contrôle via des connecteurs latéraux 83.

Le boîtier du disjoncteur 40 présente des bornes de puissance amont 41 et aval 42, accessibles pour le raccordement de conducteurs souples ou rigides par des orifices respectifs 41a,42a et à des outils de manoeuvre par des orifices frontaux 41 b,42b. Le disjoncteur 40 présente une face arrière 43 et, en saillie vers l'avant, un nez 44, muni d'au moins un bouton de commande manuelle d'ouverture/fermeture 44a. Sur le nez 44 du disjoncteur est disposé un additif de signalisation 45 doté de bornes 46 ; les bornes 46 comprennent des accès supérieurs 46a pour la connexion des broches de contrôle 25 et des orifices frontaux 46b pour la manoeuvre de ces bornes.

Le boîtier du contacteur 60 présente des bornes de puissance amont 61 et aval 62, accessibles pour le raccordement de conducteurs souples ou rigides par des orifices supérieurs 61 a et inférieurs 62a et à des outils de manoeuvre, sur une face avant 64, par des orifices frontaux 61b,62b; le boîtier du contacteur 60 offre aussi une face arrière 63 et, à côté des bornes de puissance amont 61 et aval 62, des bornes de contrôle amont 65 et aval 66 avec orifices d'accès respectifs.

Le bloc intermédiaire 50 (voir figures 4 et 5) est de faible hauteur et attache mécaniquement le contacteur au disjoncteur. Il comprend des conducteurs 51 qui assurent l'interconnexion de puissance entre disjoncteur et contacteur et se terminent à cet effet d'un côté par des broches 52 pour coopérer avec les bornes aval de puissance 42 du disjoncteur 40 et de l'autre côté par des broches 53 pour coopérer avec les bornes amont de puissance 61 du contacteur 60.

Le bloc intermédiaire 50 participe à l'assemblage mécanique du contacteur au disjoncteur par le serrage des broches 52,53 et comporte à l'arrière un talon d'emboîtement et de connexion 54. Le talon est muni de formes 54a emboîtables dans un logement 26 du socle, par exemple à l'aide de nervures et rainures. Le logement 26 présente pour coopérer avec le talon 54 une face de butée haute 26a, des faces de butée latérales 26b et des épaulements 26c de retenue vers l'avant. Le talon 54 est d'autre part muni d'éléments de connexion de contrôle 54b dirigés selon Z et coopérant avec le connecteur 81 disposé sur le circuit imprimé et accessible au fond du logement 26. Le bloc 50 possède des broches inférieures de contrôle 55 reliées aux éléments de connexion 54b, adjacentes aux broches de puissance 53 et orientées selon Z pour se connecter aux bornes de contrôle amont 65 du contacteur 60.

Le bloc intermédiaire 50 comporte un boîtier 56 et un dé de connexion 57 rapporté et fixé, par exemple par encliquetage ou tout autre moyen, dans un logement du boîtier 56 ; le dé 57 présente les conducteurs 51, noyés dans un surmoulage isolant, et leurs broches terminales 52,53. Dans le boîtier 56 est logée une paroi 56a de déviation des gaz de coupure du disjoncteur. Il convient d'observer que le bloc intermédiaire 50 présente à sa partie supérieure des formes adaptées à la préhension par un doigt de l'opérateur pour faciliter le déplacement du sous-ensemble selon Z pour son montage et son démontage.

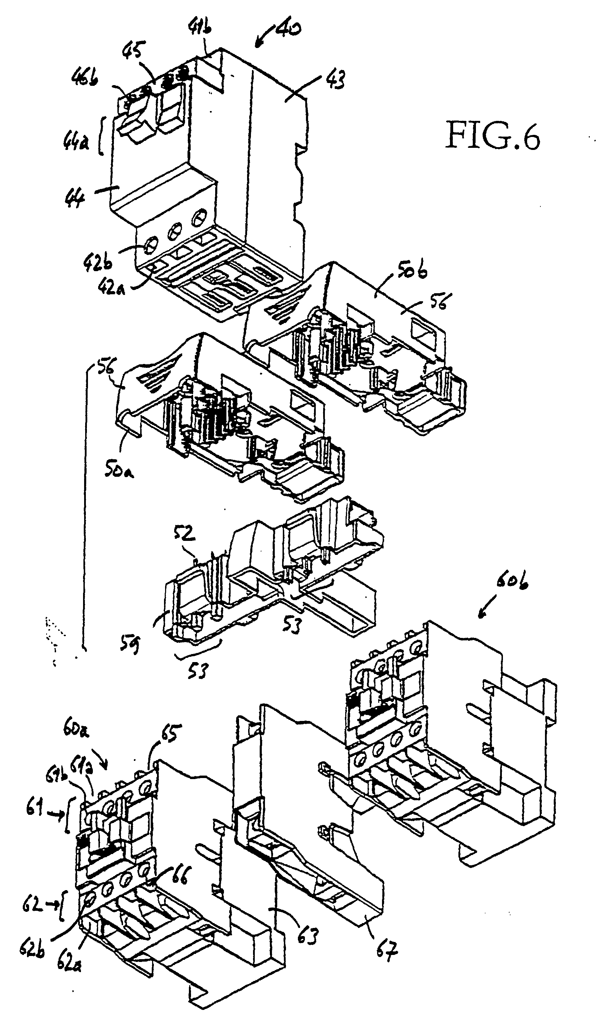

Dans une variante adaptée à une application de départ inverseur (figure 6), le disjoncteur 40 est associé à un contacteur-inverseur ou à deux contacteurs 60a,60b couplés en inverseur par un additif intermédiaire d'interverrouillage 67. Cette association a lieu au moyen de deux blocs intermédiaires juxtaposés 50a,50b dont les boîtiers 56 sont identiques à celui du bloc simple 50 précédemment décrit et qui logent un dé de connexion double 59 ; le dé 59 présente vers le haut un jeu de broches de puissance 52 coopérant avec le disjoncteur 40 et vers le bas deux jeux de broches de puissance 53 coopérant avec les deux contacteurs 60a,60b.

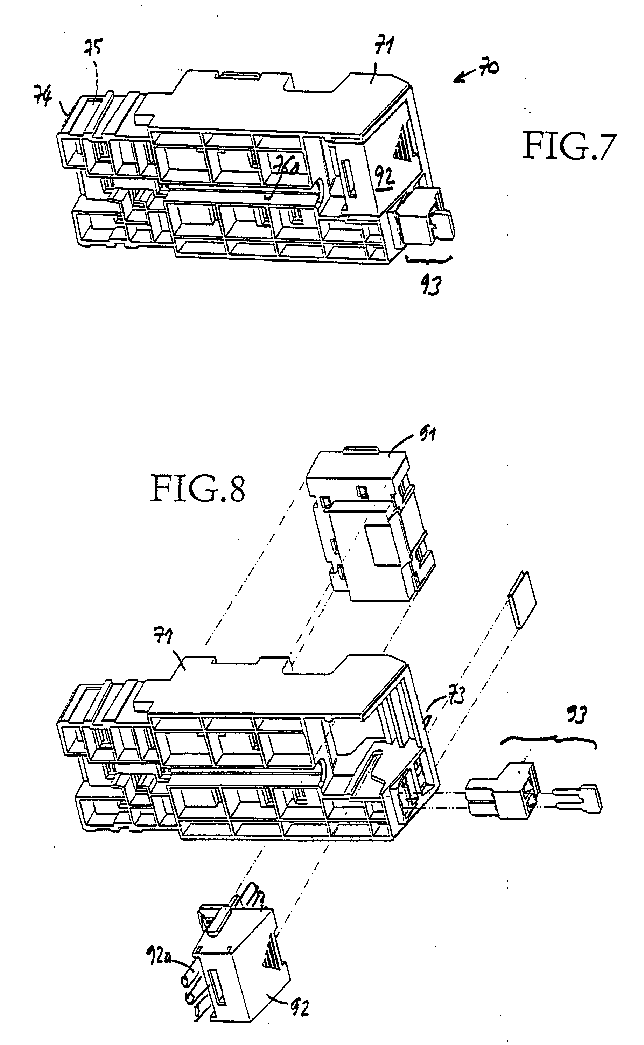

Le bloc terminal 70 (voir figures 7 et 8 comprend un boîtier 71 et des conducteurs de contrôle destinés à se connecter, par une ou plusieurs broches 73, à une ou plusieurs bornes aval 66 de contrôle du contacteur 60 ainsi qu'un passage pour des câbles de puissance reliés à la charge et à connecter aux bornes aval de puissance du contacteur. Le bloc 70 comprend un talon 74 d'emboîtement et de connexion. Ce talon est muni d'une part de formes d'emboîtement pour coopérer avec des formes, par exemple à rainures et nervures, et des parois d'un logement 27 du socle, en particulier avec une butée haute 27a, des butées latérales 27b et des épaulements de retenue avant 27c. Le talon 74 est d'autre part muni d'éléments de connexion de contrôle 75 dirigés selon Z et coopérant avec le connecteur 82 qui est lié au circuit imprimé et est accessible au fond du logement 27. Un verrou 76 commande des éléments assurant un encliquetage du bloc 70 avec des éléments coopérants du socle, notamment prévus dans le logement 27, pour confirmer l'immobilisation du sous-ensemble sur le socle. Le verrou 76 est accessible par un élément prévu à l'avant du bloc 70 ou, comme illustré, par un canal 76a du bloc.

Dans une application en inverseur, on dispose deux boîtiers 71 côte à côte et un dé dédié aux contacteurs 60a,60b.

Un relais 91 de commande de la bobine du contacteur 60 est adjoint au bloc terminal 70 pour être relié via ce bloc au connecteur 83. Un organe amovible 92 de maintien des câbles 92a du moteur est encliqueté dans un logement du boîtier 71 du bloc 70, cet organe 92 servant à éviter les inversions de phase durant les opérations de maintenance. Un shunt 93 est prévu à l'avant du bloc 70 pour permettre de connecter deux bornes de bobine vers le haut ; s'il est du type présentant une borne de bobine vers le haut et l'autre vers le bas, le bloc 70 comprend bien sûr la broche 73 nécessaire.

Le socle 20 comprend, outre les logements 26,27 et les connecteurs associés 81,82, des logements latéraux 28 comprenant des connecteurs 83 pour assurer le raccordement de connecteurs auxquels sont reliés des conducteurs de contrôle et/ou commande 90 qui assurent la liaison avec un automate programmable ou font partie d'un bus de terrain. Des logements latéraux supplémentaires 29 comprenant des connecteurs 84 sont prévus pour le raccordement de conducteurs d'alimentation à connecter à des relais prévus sur le circuit imprimé 80 lorsqu'une amplification de tension est souhaitée.

Le socle 20 illustré sur la figure 2 comprend d'un côté des éléments latéraux en relief 94 et de l'autre côté des éléments en creux complémentaires 95, afin de contribuer à l'assemblage de socles voisins. Le jeu de barres d'alimentation de puissance 23, les broches 24 reliées à ces barres et les conducteurs de contrôle qui sont reliés aux broches 25 sont surmoulés dans la console 22. Un volet pivotant 95 apte à porter des étiquettes associées aux divers groupes d'appareils est monté à l'avant de la console 22 pour cacher les débouchés des orifices d'accès 41 b,46b aux bornes du disjoncteur 40 et/ou de son additif 45. Les bornes de contrôle qui ont été décrites sont du type à serrage par vis ou à serrage par pièce élastique.

Le montage des sous-ensembles 30 sur le socle 20 du dispositif décrit est le suivant.

L'utilisateur commence par assembler le contacteur 60 au disjoncteur 40 par le bloc intermédiaire 50 en embrochant celui-ci d'un côté par les broches de puissance 52 dans les orifices 42a des bornes 42 du disjoncteur et de l'autre côté par les broches de puissance 53 et de contrôle 55 dans les orifices 61a,65a des bornes 61,65 du contacteur et en serrant les vis des bornes. Puis il engage alors le talon 54 du bloc 50 dans le logement 26 du socle, puis fait glisser le sous-ensemble dans la direction Z le long de l'aire de support 21. Le glissement s'effectue avec guidage du talon 54 dans le logement 26 jusqu'à l'accostage du connecteur 81, et engagement des cosses de puissance 24 dans les bornes 41 du disjoncteur et des broches de contrôle 25 dans les bornes 46 de son additif 45.

L'utilisateur assemble ensuite le bloc terminal 70 au contacteur en faisant glisser ce bloc selon Z pour engager son talon 74 dans le logement 27 jusqu'à l'accostage du connecteur 82, avec introduction de sa broche 73 dans l'orifice 66a de la borne de contrôle 66 du contacteur ; les câbles sont engagés dans les bornes aval de puissance du contacteur puis on serre ces bornes. Le verrou 76 s'engage dans l'élément élastique correspondant du socle et assure le maintien du sous-ensemble contre tout déplacement intempestif dans la direction Z, tandis que les butées 26b,27b retiennent le sous-ensemble dans la direction X et que les épaulements 26c,27c l'empêchent d'être arraché du socle dans la direction Y. En variante, on peut assembler le disjoncteur 40, le bloc 50 et le contacteur 60 successivement avant de confirmer leur fixation au socle par ajout et blocage du bloc 70.

La connexion de puissance de l'ensemble à une source d'énergie est réalisée par le raccordement approprié de conducteurs au bomier frontal 23a. La connexion de contrôle est réalisée par le raccordement de câbles individuels ou en nappe au connecteur latéral 83.

Pour démonter un sous-ensemble, l'utilisateur desserre les vis des bornes 41 du disjoncteur correspondant, puis déverrouille le verrou 76 et saisit les formes 58 du bloc intermédiaire 50 et le dessous du bloc terminal 70, et tire le sous-ensemble vers le bas dans la direction Z, ce mouvement étant limité par la butée du talon 54 contre le bas du logement 26, et enfin extrait le sous-ensemble du socle dans la direction X. Pour démonter seulement le contacteur d'un sous-ensemble, il suffit de desserrer les vis des bornes 61 du contacteur, puis de déverrouiller le verrou 76 et de poursuivre l'opération comme ci-dessus.

On constate qu'au montage le travail de câblage que doit effectuer l'utilisateur est considérablement réduit, car il consiste simplement à raccorder initialement la charge au contacteur, ainsi qu'à raccorder l'alimentation triphasée de puissance et la source de tension de commande des contacteurs. L'adjonction d'un ensemble voisin s'effectue avec interconnexion des connecteurs de contrôle 83 et le cas échéant 84 mis en regard et des bomiers de puissance adjacents 23a.

## Revendications

1. Ensemble d'appareils électriques affectés à la commande de puissance de charges, notamment ensemble de départ-moteur, comprenant pour chaque charge une paire d'appareils montés sur un socle, chaque paire d'appareils comportant un disjoncteur (40) et un contacteur (60) munis de bornes de puissance et de contrôle, des conducteurs de contrôle de l'ensemble d'appareils étant associés au socle,
- le socle (20) présente des broches de puissance et de contrôle coopérant avec les bornes respectives de puissance et de contrôle des appareils,
***caractérisé par le fait que** :*
- à la paire d'appareils (30) est associé au moins un bloc auxiliaire (50;70) qui est fixé à l'un au moins des appareils (40,60) de la paire, connecté à des bornes de contrôle (45 ;65,66) de cet appareil et doté de conducteurs de contrôle (56;75) raccordés aux broches de contrôle (81,82) du socle de manière telle que la paire d'appareils soit connectée au socle (20) avec une liaison de contrôle précâblée.

2. Ensemble selon la revendication 1, **caractérisé par le fait que** le bloc auxiliaire est un bloc intermédiaire amovible (50) disposé entre le disjoncteur (40) et le contacteur (60), le bloc intermédiaire assurant l'interconnexion de puissance entre le disjoncteur et le contacteur ainsi que la connexion de contrôle du contacteur (60) avec le socle (20), de sorte que la paire d'appareils est connectée au socle avec une liaison de contrôle et une liaison de puissance précâblées.

3. Ensemble selon la revendication 2, **caractérisé par le fait que** le bloc intermédiaire (50) comprend un boîtier (56) et un organe spécifique d'interconnexion de puissance (57,59) qui est rapporté et maintenu dans un logement du boîtier (56).

4. Ensemble selon la revendication 1, **caractérisé par le fait que** le bloc auxiliaire est un bloc terminal (70) attenant au contacteur (60) et assurant la connexion de contrôle du contacteur.

5. Ensemble selon la revendication 4, **caractérisé par le fait que** le bloc terminal (70) comporte un relais (91) de commande de la bobine de l'électroaimant du contacteur (60).

6. Ensemble selon la revendication 4, **caractérisé par le fait que** le bloc terminal (70) comprend pour éviter les inversions de phase un organe amovible (92) de câblage du moteur dans lequel sont serrés les câbles reliant les bornes aval de puissance (62) du contacteur (60) à la charge.

7. Ensemble selon la revendication 4, **caractérisé par le fait qu'**au bloc terminal (70) est rapporté un shunt (93) de commande externe du contacteur (60).

## Patentansprüche

1. Einheit elektrischer Geräte, die zur Leistungsregelung von Lasten eingesetzt werden, insbesondere eine Motorstarteinheit, umfassend für jede Last ein Paar auf einem Sockel eingebauter Geräte, wobei jedes Gerätepaar einen Leistungsschalter (40) und ein Schütz (60) umfasst, die mit Leistungs- und Steuerklemmen versehen sind, wobei die Steuerleiter der Geräteeinheit zu dem Sockel gehören,
- der Sockel (20) weist Leistungs- und Steuerkontaktstifte auf, die mit den entsprechenden Leistungs- und Steuerklemmen der Geräte zusammenwirken,
**dadurch gekennzeichnet, dass**
- zu dem Gerätepaar (30) gehört mindestens ein Hilfsstück (50 ; 70), das an mindestens einem der Geräte (40, 60) des Paars befestigt ist, mit den Steuerklemmen (45 ; 65, 66) dieses Geräts verbunden ist und mit Steuerleitern (56 ; 75) versehen ist, die an die Steuerkontaktstifte (81, 82) des Sockels angeschlossen sind, so dass das Gerätepaar mit dem Sockel (20) über eine vorgekabelte Steuerleitung verbunden ist.

2. Einheit nach Anspruch 1, **dadurch gekennzeichnet, dass** das Hilfsstück ein herausnehmbares Zwischenstück (50) ist, das zwischen dem Leistungsschalter (40) und dem Schütz (60) angeordnet ist, wobei das Zwischenstück die Leistungszusammenschaltung zwischen dem Leistungsschalter und dem Schütz sowie die Steuerverbindung des Schützes (60) mit dem Sockel (20) sicherstellt, so dass das Gerätepaar über vorverkabelte Steuer- und Leistungsleitungen mit dem Sockel verbunden ist.

3. Einheit nach Anspruch 2, **dadurch gekennzeichnet, dass** das Zwischenstück (50) ein Gehäuse (56) umfasst und ein spezifisches Leistungszusammenschaltungsorgan (57, 59), das in einer Aufnahme des Gehäuses (56) angebracht und gehalten wird.

4. Einheit nach Anspruch 1, **dadurch gekennzeichnet, dass** das Hilfsstück ein Endstück (70) ist, das an dem Schütz (60) anliegt und die Steuerverbindung des Schützes sicherstellt.

5. Einheit nach Anspruch 4, **dadurch gekennzeichnet, dass** das Endstück (70) ein Regelrelais (91) der Spule des Elektromagneten des Schützes (60) umfasst.

6. Einheit nach Anspruch 4, **dadurch gekennzeichnet, dass** das Endstück (70), um Phasenumkehrungen zu vermeiden, ein herausnehmbares Organ (92) zur Verkabelung des Motors umfasst, in dem die Kabel, welche die nachgeschalteten Leistungsklemmen (62) des Schützes (60) mit der Last verbinden, festgeklemmt werden.

7. Einheit nach Anspruch 4, **dadurch gekennzeichnet, dass** an dem Endstück (70) ein Nebenschluss (93) zur externen Regelung des Schützes (60) angebracht ist.

## Claims

1. An assembly of electrical equipment for the power control of loads, notably a motor starter assembly, comprising, for each load, a pair of devices mounted on a baseplate each pair of devices comprising a circuit breaker (40) and a contactor (60), fitted with power terminals and control terminals, control conductors for the equipment assembly being associated with the baseplate,
***characterised by** the fact that:*
- the baseplate (20) has power pins and control pins that co-operate with respective power terminals and control terminals for the equipment,
- at least one auxiliary unit (50, 70) is associated with the pair of devices (30) and is fixed to at least one of the devices (40, 60) of the pair, connected to the control terminals (45, 65, 66) of this device and provided with control conductors (56, 75) connected to the control pins (81, 82) of the baseplate in such a way that the pair of devices is connected to the baseplate (20) with a prewired control linkage.

2. An assembly according to Claim 1, **characterised by** the fact that the auxiliary unit is a detachable intermediate unit (50) arranged between the circuit breaker (40) and the contactor (60), the intermediate unit providing the power interconnection between the circuit breaker and the contactor as well as the control connection for the contactor (60) with the baseplate (20) in such a way that the pair of devices is connected to the baseplate with a prewired control linkage and a prewired power linkage.

3. An assembly according to Claim 2, **characterised by** the fact that the intermediate unit (50) includes a fitting (56) and a specific power interconnection device (57, 59) which is attached and held in a housing in the fitting (56).

4. An assembly according to Claim 1, **characterised by** the fact that the auxiliary unit is an end unit (70) adjoining the contactor (60) and providing the control connection for the contactor.

5. An assembly according to Claim 4, **characterised by** the fact that the end unit (70) includes a command relay (91) for the coil of the electromagnet of the contactor (60).

6. An assembly according to Claim 4, **characterised by** the fact that the end unit (70) includes, in order to avoid phase inversions, a detachable device (92) for wiring the motor in which are clamped the cables that connect the downstream power terminals (62) of the contactor (60) to the load.

7. An assembly according to Claim 4, **characterised by** the fact that an external command shunt (93) for the contactor (60) is attached to the end unit (70).
